# EUROPEAN PATENT APPLICATION

(11) **EP 4 653 138 A1**
(43) Date of publication of application: **26.11.2025**
(21) Application number: 24762571.8
(22) Date of filing: 19.02.2024
(51) Int. Cl.: B24B 53/075, B24B 49/12, H01L 21/304

(54) **DEVICE AND METHOD FOR TRUING GRINDING STONE**

(30) Priority: 28.02.2023 JP 2023029220
(71) Applicant: Tokyo Seimitsu Co., Ltd., Hachioji-shi, Tokyo 192-8515 (JP)
(72) Inventor: TSURU, Taira, Tsuchiura-shi, Ibaraki 300-0015 (JP)
(74) Representative: Seemann & Partner Patentanwälte mbB
(86) International application number: PCT/JP2024/005679
(87) International publication number: WO 2024/181194

(57) **Abstract**

Provided is a method for truing a grinding stone 16 for use in a device for chamfering a wafer W, the method comprising: truing the grinding stone 16 using a rough dressing truer 10-1 at high speed as rough machining to achieve a target rough dressing shape with a machining allowance left for truing; and truing, in a case where the grinding stone 16 fulfills an acceptable range of the target rough dressing shape, the grinding stone 16 using a fine dressing truer 10-2 larger in grit number than the rough dressing truer 10-1 as precision machining to achieve a target fine dressing shape. The method enables not only truing with high precision and high quality to a grinding stone having a complex grooved shape but also a reduction in the time required for truing to a difficult-to-machine material.

## Description

### Field

The present invention relates to a device and a method for truing a grinding stone having a grooved shape for use in a device for chamfering the end face of a semiconductor wafer.

### Background

In recent years semiconductor wafers and the like have been produced in high-mix low-volume production. Grinding stones having groove shapes used for the chamfering machining of wafers are increasingly required to meet demands of higher precision, shape modification, but also higher processing speed for the purpose of high-mix low-volume production, improved wafer quality, and higher yields.

In addition, semiconductors formed with silicon carbide (SiC), which is a compound of carbon (C) and silicon (Si), and other hard materials that have ultra-wide band gaps (UWBG) and strong interatomic bonds of crystals, such as gallium nitride (GaN), gallium oxide, AlGaN, and diamond, are expected as semiconductor materials that are more suitable to small-sized, low-power consuming, high-efficiency power elements and high-frequency elements and are higher in resistance to radioactive rays than silicon semiconductors are. Thus, the practical utilization of such semiconductors has been progressing. In particular, for UWBG materials, such as 4H-SiC, which are difficult-to-machine materials, grinding stones are strongly required to have highly precise and higher quality grooved shapes.

In chamfering machining in the process of manufacturing semiconductor row material wafers, repetition of truing (grinding) a grinding stone (fine dressing) by a truer, finely dressing a wafer, and measuring the edge shape of the wafer after grinding is required until the wafer has a desired shape. Therefore, truing to a grinding stone is required to be performed at high speed and with high precision, in particular.

As finish machining to the outer chamfer of a semiconductor wafer, it has been known to perform so called helical grinding, in which the grinding stone is inclined to the wafer and chamfer is ground, in order to prevent grinding marks from occurring in the circumferential direction. Note that, depending on a shape formed to a grinding stone by truing (depending on a case where the machined face of a grindstone after truing has a three-dimensional shape that is axially asymmetric with respect to the rotational axis (of the grindstone)), helical grinding requires subtle adjustments and time and thus needs a skilled and dedicated person.

Patent Literature 1 states that, in truing for helical grinding in which a groove is formed using a truer, to improve transfer rate and machinability as well as the precision of the groove formed by the truer, an upper or a lower groove formed on the grinding wheel is machined with the truer, and then the truer is repeatedly lowered or raised in the thickness direction relative to the grinding stone.

In addition, it has been known that truing is performed using a laser beam. Patent Literature 2 describes truing with a laser beam, in which, for less thermal influence on a target tool and high machining precision, an ultrashort pulsed laser, such as a femtosecond laser, is used and the truing is performed in a predetermined range of front and behind parts with respect to the focal point of the laser beam in the travel direction of the laser beam.

### Citation List

### Patent Literature

Patent Literature 1: Japanese Patent Application Laid-Open No. 2022-325
Patent Literature 2: Japanese Patent Application Laid-Open No. 2015-98041

### Summary

### Technical Problem

According to the technology described in Patent Literature 1 in the above conventional technologies, a skilled and dedicated person is required to adjust the movement of the truer in truing to the grinding stone for chamfering machining, and time is required for repetition of machining. In addition, with difficult-to-machine materials such as SiC, the processing is time-consuming, making it difficult to form the desired shape. The grindstone wears out rapidly, and thus it is difficult to sufficiently reduce the cost of grinding machining.

In addition, with the technology described in Patent Literature 2, it is difficult to widen the irradiation range, and the part that can be trued at one time is small, making it impossible to apply truing to the entire grinding stone. Enhancing the precision of the shape of the entire grinding stone having a grooved shape has not been taken into consideration.

For solution to the disadvantages of the above conventional technologies, an object of the present invention is to provide a method and a device for truing a grinding stone efficiently, the method and the device enabling high-precision and high-quality truing to the shape of a grinding stone having a complex grooved shape and a reduction in the time required for truing to a difficult-to-machine material.

### Solution to Problem

The present invention has the following configurations in order to achieve the above object.
[1] A device for truing a grinding stone for use in a device for chamfering a wafer, the device including: a truer including a rough dressing truer and a fine dressing truer disposed coaxially to a rotational axis of the rough dressing truer, the fine dressing truer being finer than the rough dressing truer; a first sensor that detects a first position corresponding to at least one of the rough dressing truer and the fine dressing truer in a Z direction along the rotational axis; a second sensor that detects a second position of the grinding stone in the Z direction; and a control unit that adjusts respective positions in the Z direction of the truer and the grinding stone, based on the first position and the second position.
[2] The device for truing a grinding stone according to [1], wherein the rough dressing truer and the fine dressing truer in the truer are connected together in the Z direction.
[3] The device for truing a grinding stone according to [2], including a chuck table that fixes the truer, wherein the first sensor detects the first position of the chuck table.
[4] The device for truing a grinding stone according to [3], wherein the chuck table includes a first conductor or a first magnetic material, the grinding stone includes a second conductor or a second magnetic material, and the first sensor and the second sensor are each an eddy-current sensor.
[5] The device for truing a grinding stone according to [4], wherein the truer is moved such that a difference between the first position and the second position is a particular value, whereby a central portion in the Z direction of the truer and a central position of the grinding stone are aligned.
[6] The device for truing a grinding stone according to [5], wherein a first face angle of an end face of the rough dressing truer is smaller than a second face angle of an end face of the fine dressing truer.
[7] The device for truing a grinding stone according to [2], including: a shape measurement unit that measures respective two-dimensional cross-sectional shapes of the rough dressing truer, the fine dressing truer, and the grinding stone; a displacement evaluation unit that measures deformation of the rough dressing truer or the fine dressing truer and deformation of the grinding stone; a vibration measurement unit that measures vibration of the rough dressing truer or the fine dressing truer and vibration of the grinding stone; and a machining heat evaluation unit that measures a temperature and a heat flow, wherein the control unit controls an incision amount, a rotational rate, and a position of each of the rough dressing truer and the fine dressing truer, as a machining condition, based on respective evaluations from the displacement evaluation unit, the vibration measurement unit, and the machining heat evaluation unit.
[8] The device for truing a grinding stone according to [7], including: a machining condition database in which the machining condition is associated with a measurement result from the shape measurement unit after machining; and a machining learning model constructed based on the machining condition database.
[9] A method for truing a grinding stone for use in a device for chamfering a wafer, the method including: performing, as rough machining, truing to the grinding stone using a rough dressing truer to achieve a target rough dressing shape; and performing, in a case where the grinding stone fulfills an acceptable range of the target rough dressing shape, as precision machining, the truing using a fine dressing truer larger in grit number than the rough dressing truer to achieve a target fine dressing shape.
[10] The method for truing the grinding stone according to [9], including: determining a target shape for the grinding stone and performing the truing in accordance with a truing program to which a two-dimensional cross-sectional shape of the rough dressing truer or the fine dressing truer and a two-dimensional cross-sectional shape of the grinding stone measured before machining and a displacement condition are reflected; performing, during the truing, monitoring by a displacement evaluation unit that measures deformation of the rough dressing truer or the fine dressing truer and deformation of the grinding stone, a vibration measurement unit that measures vibration of the rough dressing truer or the fine dressing truer and vibration of the grinding stone, and a machining heat evaluation unit that measures a temperature and a heat flow; databasing, as a machining condition database, a machining condition and a measurement result from a shape measurement unit that measures a two-dimensional cross-sectional shape of the rough dressing truer or the fine dressing truer and a two-dimensional cross-sectional shape of the grinding stone after machining, the machining condition and the measurement result being in association with each other; and constructing a machining learning model based on the machining condition database.

### Advantageous Effects of Invention

According to the present invention, truing with a rough dressing truer is performed to a grinding stone at high speed as rough machining to leave a machining allowance. In a case where the grinding stone fulfills an acceptable range of a target rough dressing shape, truing with a fine dressing truer larger in grit number than the rough dressing truer is performed to the grinding stone as precision machining. Thus, not only truing with high precision and high quality can be performed to a grinding stone having a complex grooved shape, but the time required for truing can also be reduced for difficult-to-machine materials.

### Brief Description of Drawings

FIG. 1A is a partial sectional view illustrating a truer according to an embodiment of the present invention.
FIG. 1B is a partial sectional view illustrating a truer according to an embodiment of the present invention.
FIG. 2 is a view illustrating a procedure of chamfering machining to a wafer.
FIG. 3 is an explanatory view for factors related to the precision of machining at the time of truing.
FIG. 4 is an explanatory view for positioning between the truer and a grinding stone according to the embodiment.
FIG. 5 is a configuration view of a positioning unit according to the embodiment.
FIG. 6 is a block diagram illustrating the entire system configuration of a device for truing according to the embodiment.
FIG. 7 is a flowchart of a method for truing according to the embodiment.

### Description of Embodiments

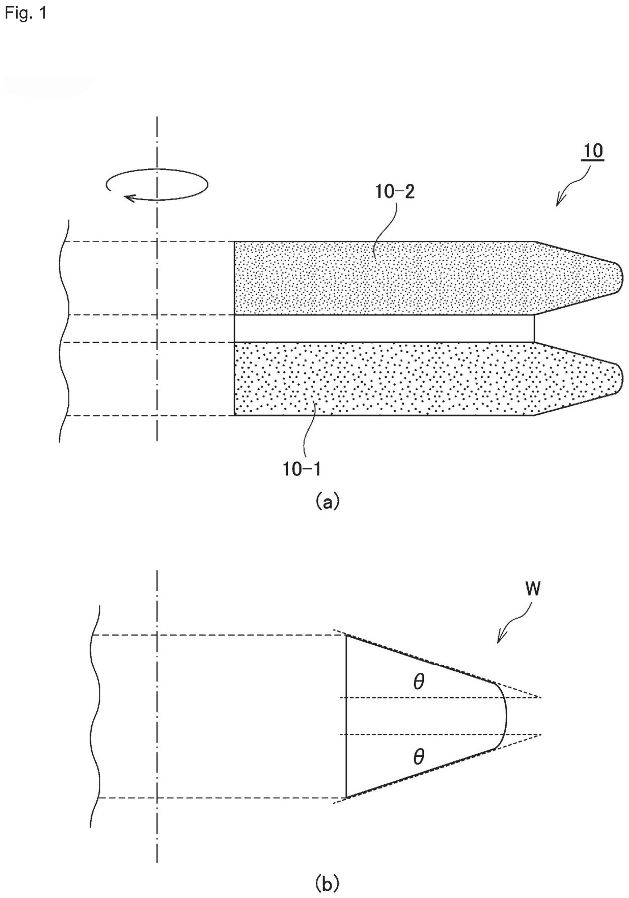

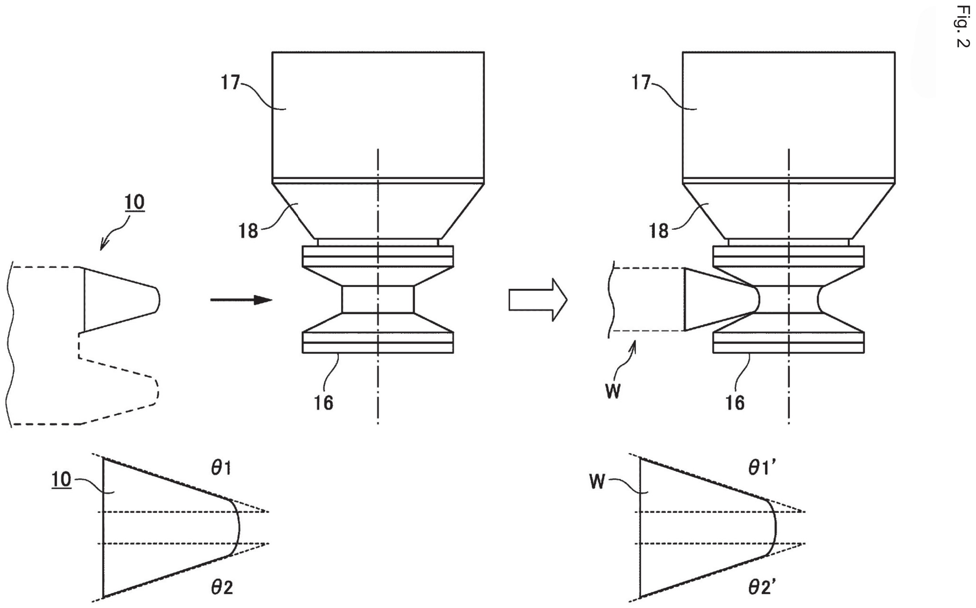

FIG. 1A and 1B are each partial sectional views illustrating a truer 10 according to an embodiment of the present invention. FIG. 2 is a view illustrating a procedure of chamfering machining to the end face of a wafer by a device for chamfering. In chamfering machining, shape transfer or machining (truing) is performed to a grinding stone 16 by the truer 10, and then the shape of a wafer W is subjected to grinding machining by the grinding stone 16. Referring to FIG. 2, the grinding stone 16 is mounted on a grindstone spindle 17 through a quill 18 and rotates. Because of helical grinding, the truer 10 has an upper face angle θ1 and a lower face angle θ2 at its end face, and the wafer W is subjected to shape transfer to have an upper face angle θ1' and a lower face angle θ2'. For example, the upper face angle θ1 of the truer 10 corresponds to the angle of the upper slope of the end of the truer 10, and the lower face angle θ2 of the truer 10 corresponds to the angle of the lower slope of the end of the truer 10. For example, the upper face angle θ1' of the wafer W corresponds to the angle of the upper slope of the end of the wafer W, and the lower face angle θ2' of the wafer W corresponds to the angle of the lower slope of the end of the wafer W. Such an upper face angle and/or a lower face angle may be simply referred to as a face angle.

The truer 10 includes a rough dressing truer 10-1 for rough machining and a fine dressing truer 10-2 for finish machining. The truer 10 may have the rough dressing truer 10-1 and the fine dressing truer 10-2 interchangeable. As illustrated in FIG. 1A, the cross-sectional shape of the rough dressing truer 10-1 and the cross-sectional shape of the fine dressing truer 10-2 are substantially identical to each other. Note that the cross-sectional shape of the rough dressing truer 10-1 and the cross-sectional shape of the fine dressing truer 10-2 may be identical to each other or may be different from each other.

The rough dressing truer 10-1 may be disposed coaxially to the fine dressing truer 10-2. Note that the axes of the fine dressing truer 10-1 and the fine dressing truer 10-2 may be slightly misaligned.

For example, as illustrated in FIG. 1A, the truer 10 includes the rough dressing truer 10-1 and the fine dressing truer 10-2 that are integrally formed in a two-tiered manner. The rough dressing truer 10-1 and the fine dressing truer 10-2 may be directly bonded together or may be connected through a member including metal, resin, or the like.

In the example illustrated in FIG. 1A, the fine dressing truer 10-2 is provided above the rough dressing truer 10-1 (or is bonded to the rough dressing truer 10-1 from above). Note that the fine dressing truer 10-2 may be provided below the rough dressing truer 10-1 (or may be bonded to the rough dressing truer 10-1 from below).

Then, due to truing with the rough dressing truer 10-1 as rough machining, high-speed removal is performed to achieve a target rough dressing shape with a machining allowance, which is 10 to 20% the size of the final target shape (target fine dressing shape) for the grinding stone 16, left. That is, the target rough dressing shape is 80 to 90% the size of the target fine dressing shape. Thus, truing with the rough dressing truer 10-1 is performed faster than truing with the fine dressing truer 10-2 such that a machining allowance for the fine dressing truer 10-2 is left, leading to an improvement in the efficiency of grinding.

After truing with the rough dressing truer 10-1, truing with the fine dressing truer 10-2 is performed. Truing with the fine dressing truer 10-2 is performed as precision machining with high precision to the part left after rough machining. Thus, the face angle of the rough dressing truer 10-1 is smaller by an angle of 1 to 3 degrees than a face angle θ as a designed value for the wafer W as illustrated in FIG. 1B.

In addition, the face angle of the rough dressing truer 10-1 is preferably smaller than the face angle of the fine dressing truer 10-2. Note that, as a machining condition, an adjustment may be made with the rough dressing truer 10-1 and the fine dressing truer 10-2 regarded as having their shapes as exactly the same. The grit number of the grinding stone (grain size of the grinding stone) of the fine dressing truer 10-2 is larger than that of the rough dressing truer 10-1, and the grain size of the fine dressing truer 10-2 is smaller than that of the rough dressing truer 10-1. In other words, the fine dressing truer 10-2 is finer than the rough dressing truer 10-1.

As illustrated in FIG. 1A, truing with the rough dressing truer 10-1 and the fine dressing truer 10-2 is performed due to a machining program, for example, based on a machining condition database in which histories of rough machining enabling great approach to the target shape and machining are accumulated, so that a reduction can be made in the time required for truing. Note that the rough dressing truer 10-1 and the fine dressing truer 10-2 may be integrated together in a two-tiered manner as illustrated in FIG. 1A or may be separate such that each can be replaced independently. Even in a case where the rough dressing truer 10-1 and the fine dressing truer 10-2 are separate and are each replaced depending on usage, the rough dressing truer 10-1 and the fine dressing truer 10-2 can be each replaced faster by positioning in the present embodiment, described later, than by positioning by eye.

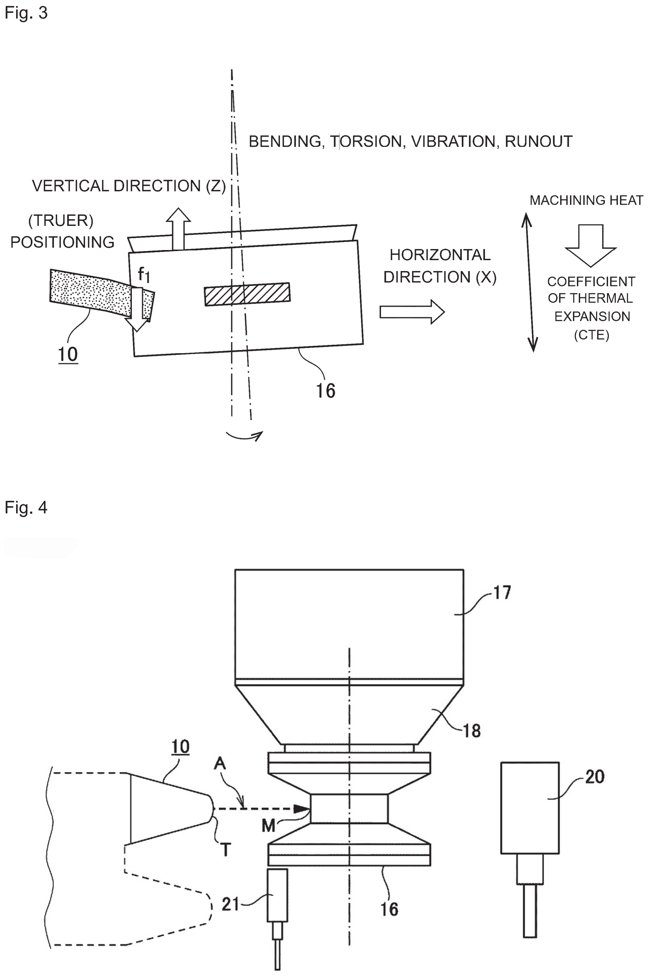

FIG. 3 is an explanatory view for factors related to the precision of machining at the time of truing. Desirably, truing is automated such that an improvement is made in quality with controlled precision. In contrast to this, currently, truing is performed, for example, based on positioning by eye and under machining conditions created based on craftsman's intuitions. Then, in particular, the work of truing for helical grinding is time-consuming and may require half a day or more for setting various conditions.

Examples of factors related to the precision of machining include the bending, torsion, vibration, and runout of the grinding stone 16, the surface shape and abrasive grain state of the truer 10, force f₁ applied at the time of shape transfer, the deformation of the truer 10, machining heat, the coefficient of thermal expansion (CTE), and positioning between the truer 10 and the grinding stone 16. Thus, for an improvement in the precision of machining, construction of a machining control model based on analysis of the influence of deformation, based on force, heat, and the like, on the precision of machining, specification of factors having strong influences on performance, and machine learning for automation are required. In particular, it is important to sense the positions of the truer 10 and the grinding stone 16 in a grinding environment and to perform positioning based on measurement.

FIG. 4 is an explanatory view for positioning between the truer 10 and the grinding stone 16. A laser displacement meter 20 measures the two-dimensional cross-sectional shapes of the truer 10 and the grinding stone 16. Based on the measurement by the laser displacement meter 20, the position at which an end central portion T of the truer 10 and a groove-bottom central position M of the grinding stone 16 are aligned is set as a reference position, and then the end central portion T of the truer 10 is moved to the groove-bottom central position M of the grinding stone 16 for positioning.

For positioning, eddy-current sensors 21-1 and 21-2 detect, respectively, the position of a first conductor (or magnetic material) 23-1 embedded in the grinding stone 16 and the position of a second conductor (or magnetic material) 23-2 embedded in a chuck table 24 that fixes the truer 10. Note that an eddy-current sensor 21 measures grindstone displacement due to machining force during machining to determine in advance the relationship in grinding force and deformation between the truer 10 and the grinding stone 16.

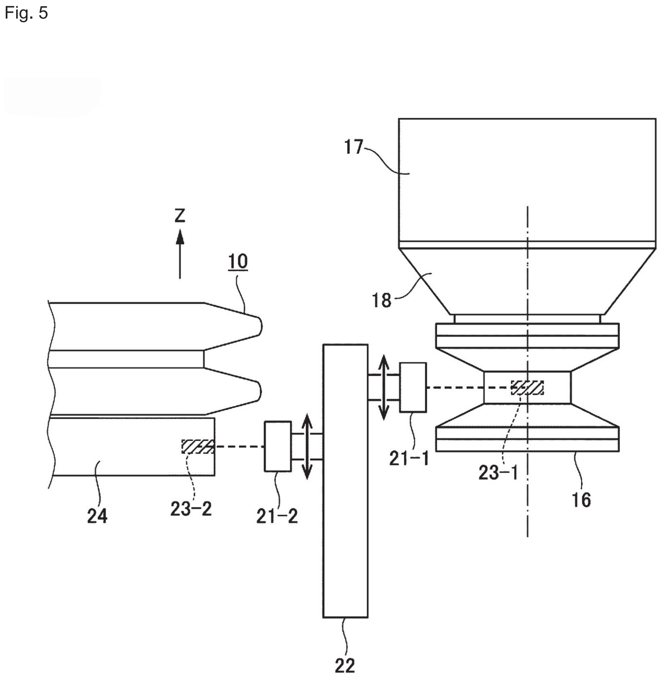

FIG. 5 is a configuration view of a positioning unit, in which the truer 10 is fixed to the chuck table 24. The second conductor (or magnetic material) 23-2 is embedded in the chuck table 24. The first conductor (or magnetic material) 23-1 is embedded in a groove-bottom central portion of the grinding stone 16. A moving stage 22 has a length measuring function and is equipped with the eddy-current sensors 21-1 and 21-2.

The eddy-current sensor 21-1 is attached movably in a Z direction on the opposite side of the first conductor (or magnetic material) 23-1 and determines, as Z1, the position of the groove-bottom central portion of the grinding stone 16. The eddy-current sensor 21-2 is attached movably in the Z direction on the opposite side of the second conductor (or magnetic material) 23-2 and determines, as Z2, the position of the end central portion T of the truer 10. For positioning between the end central portion T of the truer 10 and the groove-bottom central position M of the grinding stone 16, the truer 10 is moved such that the difference between Z1 and Z2 is a predetermined value, so that the set reference position is fulfilled. Note that, in the embodiment, the sensor that detects the position of the truer 10 (or the chuck table 14) and the sensor that detects the position of the grinding stone 16 are the eddy-current sensor 21-1 and the eddy-current sensor 21-2, respectively. However, any other sensors different from the eddy-current sensors 21-1 and 21-2 may be used, provided that the position of the truer 10 (or the chuck table 14) and the position of the grinding stone 16 can be each detected.

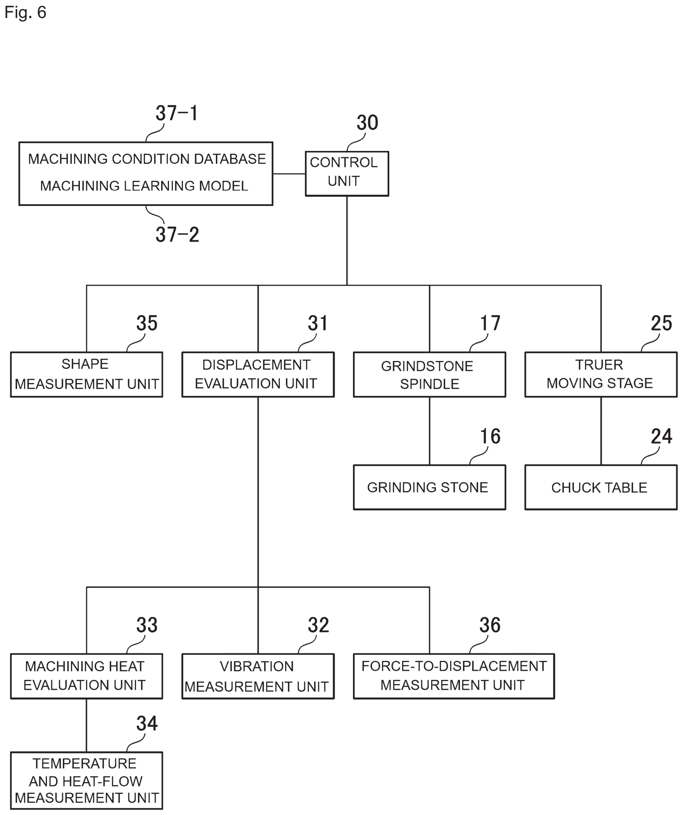

FIG. 6 is a block diagram illustrating the entire system configuration of a device for truing the grinding stone 16. A control unit 30 controls (or adjusts), as a machining condition, the incision amount, rotation rate, position, and the like of the truer 10, based on evaluations from a displacement evaluation unit 31, a vibration measurement unit 32, and a machining heat evaluation unit 33. The displacement evaluation unit 31 evaluates deformation (displacement) based on the truer 10 and the grinding stone 16 at the time of machining, based on a measurement value from a force-to-displacement measurement unit 36.

For example, the displacement evaluation unit 31 applies a known force to the truer 10 and measures the displacement of the truer 10 at the time to make a model in advance. The displacement evaluation unit 31 measures the deformation of the truer 10 and the deformation of the grinding stone 16 during machining (displacements from the no-load state) and then performs rating (numerical conversion based on the criterion). The vibration measurement unit 32 measures the vibration of the truer 10 and the vibration of the grinding stone 16 during machining.

The vibration measurement unit 32 may be in common with the laser displacement meter 20 and the eddy-current sensor 21 illustrated in FIG. 4. The machining heat evaluation unit 33 evaluates the machining heat of the truer 10 and the machining heat of the grinding stone 16, using a measured temperature value and a measured heat-flow value from a thermocouple and a heat flow meter included in a temperature and heat-flow measurement unit 34.

A shape measurement unit 35 includes, for example, the laser displacement meter 20 and measures at least the two-dimensional cross-sectional shapes of the truer 10 and the grinding stone 16. The grinding stone 16 is mounted on the grindstone spindle 17. The truer 10 is fixed to the chuck table 24 placed on a truer moving stage 25 and is rotatable around its axis of rotation. The truer 10 is movable in a plurality of directions one-to-one along X, Y, and Z axes. A machining condition database 37-1 stores the monitored machining condition and a measurement result from the shape measurement unit 35 after machining, the monitored machining condition and the measurement result being in association with each other. A machining learning model 37-2 is constructed with the stored result. Note that the control unit 30 further controls a cooling water system to grinding heat.

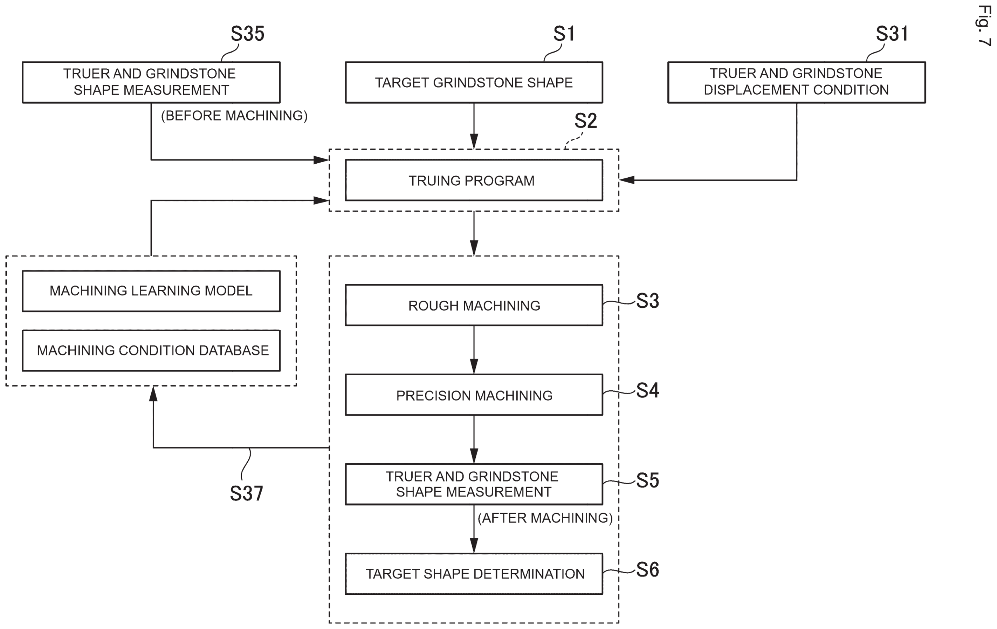

FIG. 7 is a flowchart of a method for truing. First, a target shape is determined for the grinding stone 16, and then the target shape is converted into data. (Step S1)

In Step S1, the two-dimensional cross-sectional shapes of the truer 10 and the grinding stone 16 measured before machining in Step S35 and the displacement condition between the truer 10 and the grinding stone 16 (relationship between grinding force and deformation) modeled in Step S31 are reflected to a truing program (Step S2). (Step S2)

The following series of processes are performed in accordance with the truing program. In rough machining, truing with the rough dressing truer 10-1 is performed to the grinding stone 16 to achieve the target rough dressing shape with an allowance left for the following precision machining. (Step S3)

In Step S3, as illustrated in FIG. 4, with the position, at which the end central portion T of the rough dressing truer 10-1 and the groove-bottom central position M of the grinding stone 16 are aligned, set as the reference position due to measurement by the laser displacement meter 20, rough machining is performed.

After the rough machining, the shapes of the truer 10 and the grinding stone 16 are measured by the laser displacement meter 20 in the shape measurement unit 35 and are compared to the target rough dressing shape, and then it is determined whether the processing should proceed to the following precision machining. In a case where the grinding stone 16 subjected to truing is out of the acceptable range of the target rough dressing shape, the processing goes back to the process of rough machining in Step 3. Due to the measurement of the shape of the truer 10, the machining condition and the two-dimensional cross-sectional shape after machining are databased in association with each other as the machining condition database 37-1 to construct the machining learning model 37-2, leading to contribution to an enhancement in precision.

In a case where the grinding stone 16 fulfills the acceptable range of the target rough dressing shape, truing with the fine dressing truer 10-2 is performed to the grinding stone 16 to achieve the target fine dressing shape. (Step S4)

In Step S4, with the position, at which the end central portion T of the fine dressing truer 10-2 and the groove-bottom central position M of the grinding stone 16 are aligned, set as the reference position due to measurement by the laser displacement meter 20, precision machining is performed. After the precision machining, the shapes of the fine dressing truer 10-2 and the grinding stone 16 are measured by the laser displacement meter 20 in the shape measurement unit 35 (Step S5), and then a determination is made in quality. (Step S6)

In a case where the fine dressing truer 10-2 subjected to truing is out of the acceptable range of the target fine dressing shape, the processing goes back to the process of precision machining in Step 4. In a case where the acceptable range of the target fine dressing shape is fulfilled, the wafer W is ground by the grinding stone 16 subjected to shape transfer and then a determination is made in quality based on the edge set value (target value).

For determination of the quality of the truer 10 in Step 3 and Step S4, the result accumulated in advance in the machining condition database 37-1 may be used. In addition, for determination of the quality of the grinding stone 16 after rough machining in Step 3, use of the result accumulated in the machining condition database 37-1 is preferable.

In the series of processes from Step 3 to Step 6, for example, due to monitoring with the displacement evaluation unit 31, the vibration measurement unit 32, and the machining heat evaluation unit 33 during truing, the machining condition and a result from the shape measurement unit 35 after machining are databased in association with each other. (Step S37)

The machining learning model 37-2 for high-precision and high-speed machining is constructed based on the machining condition database 37-1 resulting from databasing. The truing program refers to the machining learning model 37-2.

The machining learning model 37-2 serves as a machine learning model that outputs a computer-based evaluated/determined result to input data. For example, the machining learning model 37-2 receives, as inputs, the values monitored by the displacement evaluation unit 31, the vibration measurement unit 32, and the machining heat evaluation unit 33 to output an optimum machining condition. The truing program inputs an inquiry to the machining learning model 37-2 as necessary to obtain an evaluated/determined result.

As described above, according to the above embodiment, in the process of manufacturing semiconductor wafers, truing to the grinding stone 16 related to chamfering machining is performed in two steps using the rough dressing truer 10-1 and the fine dressing truer 10-2. Thus, even in helical grinding to a difficult-to-machine material, an improvement can be made in machining speed and a high-precision grooved shape can be achieved. In addition, due to rough machining enabling great approach to the target shape and the truing program enabling an efficient tool path using the machining condition database 37 and the machining learning model 37-2, a reduction can be made in the time required for truing.

Shape transfer from the truer 10 has been described with FIGS. 2 and 3. For a further enhancement in precision, preferably, the upper portion or lower portion of the groove formed on the grinding stone 16 is machined by the fine dressing truer 10-2 and then the truer 10 is moved downward or upward, in the thickness direction of the grinding stone 16, relative to the grinding stone 16 to grind the other portion.

Removing most part by truing with the rough dressing truer 10-1 to the grinding stone 16 to make the grinding stone 16 approach to the target shape and then performing truing with the fine dressing truer 10-2 to the grinding stone 16 with high precision are applicable to a case where the wafer W is formed with a difficult-to-machine material, such as 4H-SiC or a different polytype (e.g., 3C-SiC, 6H-SiC, or 15R-SiC), or a difficult-to-machine material having a wide band gap, such as gallium nitride (GaN), gallium oxide, or AlGaN. Then, even for a difficult-to-machine material, a reduction in the machining time based on the grinding stone 16 and an enhancement in quality, particularly, highly precise shape formation and a uniform surface state (waviness or roughness) favorable to the post-process can be achieved.

### Reference Signs List

- 10: TRUER
- 10-1: ROUGH DRESSING TRUER
- 10-2: FINE DRESSING TRUER
- 16: GRINDING STONE
- 17: GRINDSTONE SPINDLE
- 18: QUILL
- 20: LASER DISPLACEMENT METER
- 21: EDDY-CURRENT SENSOR
- 22: MOVING STAGE
- 23-1: FIRST CONDUCTOR
- 23-2: SECOND CONDUCTOR
- 24: CHUCK TABLE
- 25: TRUER MOVING STAGE
- 30: CONTROL UNIT
- 31: DISPLACEMENT EVALUATION UNIT
- 32: VIBRATION MEASUREMENT UNIT
- 33: MACHINING HEAT EVALUATION UNIT
- 34: TEMPERATURE AND HEAT-FLOW MEASUREMENT UNIT
- 35: SHAPE MEASUREMENT UNIT
- 36: DISPLACEMENT MEASUREMENT UNIT
- 37-1: MACHINING CONDITION DATABASE
- 37-2: MACHINING LEARNING MODEL
- M: GROOVE-BOTTOM CENTRAL POSITION
- T: END CENTRAL PORTION
- W: WAFER

## Claims

1. A device for truing a grinding stone for use in a device for chamfering a wafer, the device comprising:
a truer including a rough dressing truer and a fine dressing truer disposed coaxially to a rotational axis of the rough dressing truer, the fine dressing truer being finer than the rough dressing truer;
a first sensor that detects a first position corresponding to at least one of the rough dressing truer and the fine dressing truer in a Z direction along the rotational axis;
a second sensor that detects a second position of the grinding stone in the Z direction; and
a control unit that adjusts respective positions in the Z direction of the truer and the grinding stone, based on the first position and the second position.

2. The device for truing a grinding stone according to claim 1, wherein the rough dressing truer and the fine dressing truer in the truer are connected together in the Z direction.

3. The device for truing a grinding stone according to claim 2, comprising a chuck table that fixes the truer, wherein
the first sensor detects the first position of the chuck table.

4. The device for truing a grinding stone according to claim 3, wherein
the chuck table includes a first conductor or a first magnetic material,
the grinding stone includes a second conductor or a second magnetic material, and
the first sensor and the second sensor are each an eddy-current sensor.

5. The device for truing a grinding stone according to claim 4, wherein the truer is moved such that a difference between the first position and the second position is a particular value, whereby a central portion in the Z direction of the truer and a central position of the grinding stone are aligned.

6. The device for truing a grinding stone according to claim 5, wherein a first face angle of an end face of the rough dressing truer is smaller than a second face angle of an end face of the fine dressing truer.

7. The device for truing a grinding stone according to claim 2, comprising:
a shape measurement unit that measures respective two-dimensional cross-sectional shapes of the rough dressing truer, the fine dressing truer, and the grinding stone;
a displacement evaluation unit that measures deformation of the rough dressing truer or the fine dressing truer and deformation of the grinding stone;
a vibration measurement unit that measures vibration of the rough dressing truer or the fine dressing truer and vibration of the grinding stone; and
a machining heat evaluation unit that measures a temperature and a heat flow, wherein
the control unit controls an incision amount, a rotational rate, and a position of each of the rough dressing truer and the fine dressing truer, as a machining condition, based on respective evaluations from the displacement evaluation unit, the vibration measurement unit, and the machining heat evaluation unit.

8. The device for truing a grinding stone according to claim 7, comprising:
a machining condition database in which the machining condition is associated with a measurement result from the shape measurement unit after machining; and
a machining learning model constructed based on the machining condition database.

9. A method for truing a grinding stone for use in a device for chamfering a wafer, the method comprising:
performing, as rough machining, truing to the grinding stone using a rough dressing truer to achieve a target rough dressing shape; and
performing, in a case where the grinding stone fulfills an acceptable range of the target rough dressing shape, as precision machining, the truing using a fine dressing truer larger in grit number than the rough dressing truer to achieve a target fine dressing shape.

10. The method for truing the grinding stone according to claim 9, comprising:
determining a target shape for the grinding stone and performing the truing in accordance with a truing program to which a two-dimensional cross-sectional shape of the rough dressing truer or the fine dressing truer and a two-dimensional cross-sectional shape of the grinding stone measured before machining and a displacement condition are reflected;
performing, during the truing, monitoring by a displacement evaluation unit that measures deformation of the rough dressing truer or the fine dressing truer and deformation of the grinding stone, a vibration measurement unit that measures vibration of the rough dressing truer or the fine dressing truer and vibration of the grinding stone, and a machining heat evaluation unit that measures a temperature and a heat flow;
databasing, as a machining condition database, a machining condition and a measurement result from a shape measurement unit that measures a two-dimensional cross-sectional shape of the rough dressing truer or the fine dressing truer and a two-dimensional cross-sectional shape of the grinding stone after machining, the machining condition and the measurement result being in association with each other; and
constructing a machining learning model based on the machining condition database.
